# EUROPÄISCHE PATENTSCHRIFT

(11) **EP 0 413 891 B1**
(45) Veröffentlichungstag und Bekanntmachung des Hinweises auf die Patenterteilung: **04.05.1994**
(21) Anmeldenummer: 90104433.9
(22) Anmeldetag: 08.03.1990
(51) Int. Cl.: G01P 3/48

(54) **Verfahren und Schaltungsanordnung zur Erzeugung einer Eingangsgrösse für ein Kreuzspulanzeigeinstrument**
Process and appliance forming an input signal for a crossed-coil type indicating instrument
Procédé et dispositif pour former un signal d'entrée pour un instrument indicateur du type à enroulements croisés

(30) Priorität: 24.08.1989 DE 3927966
(43) Veröffentlichungstag der Anmeldung: 27.02.1991
(73) Patentinhaber: VDO Adolf Schindling AG, D-60487 Frankfurt (DE)
(72) Erfinder: Haussman, Bernd, Dipl.-Ing., D-6240 Königstein (DE); Belz, Robert, Dipl.-Ing., D-6200 Wiesbaden (DE)
(74) Vertreter: Klein, Thomas, Dipl.-Ing. (FH)

(56) Entgegenhaltungen:
- EP-A- 0 031 702
- EP-A- 0 031 703
- WO-A-87/03978
- DE-A- 3 339 231
- DE-A- 3 434 189
- GB-A- 2 057 693

## Beschreibung

Die Erfindung betrifft ein Verfahren zur Erzeugung eines zur Frequenz eines Meßsignals proportionalen Eingangsstroms für ein Kreuzspulanzeigeinstrument, wobei mittels einer konstanten Zählfrequenz zunächst Zahlenwerte entsprechend der Dauer zwischen den steigenden Flanken zweier aufeinanderfolgender Impulse des Meßsignals und daraus mittels Dividierwerk Zahlenwerte entsprechend der Frequenz des Meßsignals gebildet werden, die dann in einem digitalen Regler mit Dämpfungsschaltung in Eingangs-Zahlenwerte für eine Ansteuerlogik umgewandelt werden, aus denen die Ansteuerlogik die Eingangsströme für das Kreuzspulanzeigeinstrument erzeugt. Weiterhin betrifft die Erfindung eine Schaltungsanordnung zur Durchführung des Verfahrens.

Ein derartiges Verfahren und eine derartige Schaltungsanordnung sind aus EP 218 737 A bekannt. Von einer Eingangsfrequenz wird die Periodendauer ermittelt und durch Kehrwertbildung in ein 10-Bit-Digitalwort umgewandelt. Zum Ausgleich von Schwankungen der Frequenz des Eingangssignals dient eine Verarbeitungsschaltung, die eine digitale Regelungseinrichtung aufweist, die im bekannten Fall nach einem PT₂-Algorithmus arbeitet. Das Ergebnis der Regelung wird in einen geeigneten Eingangsstrom für das Kreuzspulanzeigeinstrument umgesetzt. "Eingangsstrom" ist dabei ein Sammelbegriff für die Verteilung der den einzelnen Spulen des Kreuzspulanzeigeinstruments zugeführten Ströme.

Kreuzspulinstrumente werden bevorzugt auch zur Anzeige von nicht-elektrischen Größen eingesetzt, beispielsweise zur Anzeige von Motor-Drehzahlen oder Geschwindigkeiten in einem Kraftfahrzeug. Die bei solchen Messungen entstehenden Größen umfassen einen relativ großen Frequenzbereich, so daß üblicherweise eine Periodenmessung sowie eine eingangssynchrone Verarbeitung erforderlich sind. Aufgrund der eingangssynchronen Verarbeitung ergibt sich bei niedrigen Frequenzen des Meßsignals ein unbefriedigendes Anzeigeverhalten. Der Zeiger ändert dann von Zeit zu Zeit ruckweise seine Stellung, was vom Betrachter als unangenehm empfunden wird.

Es ist die Aufgabe der vorliegenden Erfindung, ein Verfahren und eine Schaltungsanordnung anzugeben, mit der eine Eingangsgröße für ein Kreuzspulanzeigeinstrument erzeugt werden kann, die ein angenehmeres Anzeigeverhalten ermöglicht.

Diese Aufgabe wird bei einem Verfahren der eingangs genannten Art dadurch gelöst, daß der digitale Regler oberhalb eines ersten vorbestimmten Frequenzwertes mit der Frequenz des Meßsignals und unterhalb des ersten vorbestimmten Frequenzwertes mit einer konstanten Taktfrequenz betrieben wird und daß dem digitalen Regler unterhalb eines zweiten vorbestimmten Frequenzwerts ein vom Meßsignal unabhängiger, Konstanter Zahlenwert zugeführt wird. Mit diesem Verfahren wird sichergestellt, daß unterhalb einer Grenzfrequenz des Eingangssignals die eingangssynchrone Verarbeitung des Meßwertes und die mit gleicher Frequenz erfolgende Ansteuerung des Kreuzspulanzeigeinstrument durch eine Verarbeitung und Ansteuerung mit einer von der Frequenz des Eingangssignals unabhängigen, konstanten Frequenz ersetzt wird.

Diese Frequenz ist so hoch gewählt, daß die wegen der digitalen Meßwertverarbeitung und Ansteuerung zwangsläufig schrittweise Änderung der Zeigerstellung vom Auge als stetige Bewegung wahrgenommen wird. Würde man die Ansteuerung auch im unteren Teil des Anzeigebereichs eingangssynchron, d. h. mit der Frequenz des Eingangssignals vornehmen, käme man unterhalb der Grenzfrequenz bei weiter sinkendem Wert des Eingangssignals schließlich in einen Bereich, in dem die Änderung der Zeigerstellung unabhängig von der Größe der Einzelschritte vom Auge als Folge von Einzelschritten erkannt wird. Bei dem bekannten Verfahren (EP-A-0 218 737) wird durch die Dämpfungs- bzw. Verzögerungsschaltung sichergestellt, daß starke Änderungen der Eingangsgröße nicht auf die Zeigerbewegung durchschlagen und als solche in Erscheinung treten; bei dem erfindungsgemäßen Verfahren wird außerdem dafür gesorgt, daß die eingangssynchrone Verarbeitung des Meßßwertes und die mit gleichem Takt erfolgende Ansteuerung des Kreuzspulanzeigegeräts nur oberhalb einer Grenzfrequenz angewandt wird und daß unterhalb der Grenzfrequenz mit einer ausreichend großen, konstanten Taktfrequenz gearbeitet wird.

Vorteilhafte Ausbildungen und Ergänzungen desVerfahrens sind in den abhängigen Ansprüchen 2 bis 5 beschrieben, während sich die Ansprüche 6 bis 8 auf eine Schaltungsanordnung zur Durchführung des Verfahrens beziehen.

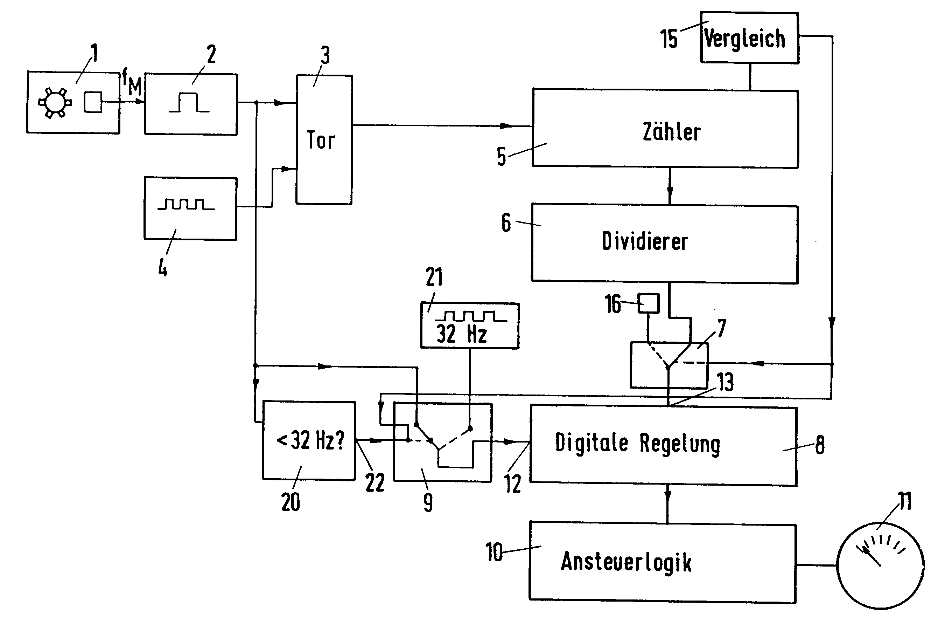

Die Erfindung wird im folgenden anhand eines Ausführungsbeispiels in Verbindung mit der Zeichnung beschrieben. Die Fig. zeigt eine Schaltungsanordnung.

Ein Signalgeber 1 erzeugt an seinem Ausgang ein Signal f_{M} in Abhängigkeit von einer zu messenden Größe, beispielsweise der Drehzahl eines Motors oder der Geschwindigkeit eines Fahrzeugs. Die Signalerzeugung kann dabei in bekannter Weise durch einen induktiven oder optischen Geber erfolgen, der in Abhängigkeit von der zu messenden Drehzahl bzw. der zu messenden Geschwindigkeit eine Folge von Impulsen erzeugt. Die Impulsfolge mit der Frequenz f_{M} werden in einem Impulsformer 2 geformt und einem Eingang einer Torschaltung 3 zugeführt. Der andere Eingang der Torschaltung 3 ist mit einem Ausgang eines Zählerfrequenzgenerators 4 verbunden. Der Ausgang der Torschaltung 3 ist mit einem Eingang eines Zählers 5 verbunden. Solange der Ausgang des Impulsformers 2 beispielsweise auf einem Pegel logisch 1 ist, ist die Torschaltung 3 für die Impulse des Zählerfrequenzgenerators 4 geöffnet, so daß der Zähler 5 die Anzahl der Impulse des Zählerfrequenzgenerators 4 zählen kann, die während dieser Zeit die Torschaltung 3 passieren. Aufgrund der durch den Zähler 5 ermittelten Zahl läßt sich eine Aussage über die Länge der Periode des Signals des Signalgebers 1 treffen. Der Ausgang des Zählers 5 ist mit einem Eingang eines Dividierers 6 verbunden, der den Kehrwert der Periodenlänge bildet und damit die Frequenz des Signals des Signalgebers 1 ermittelt. Am Ausgang des Dividierers 6 erscheint eine der Frequenz f_{M} des Signals des Signalgebers 1 proportionale digitale Zahl, die über einen ersten Umschalter 7 an einen Signaleingang 13 einer digitalen Regelung 8 weitergeleitet wird. Ein Takteingang 12 der digitalen Regelung 8 ist über einen zweiten Umschalter 9 mit dem Ausgang des Impulsformers 2 verbunden, so daß die digitale Regelung 8 im Normalfall mit der Frequenz f_{M} des Signals des Signalgebers 1 getaktet wird. Am Ausgang der digitalen Regelung 8 erscheint eine digitale Zahl, die einem Eingang einer Ansteuerlogik 10 zugeführt wird, die in Abhängigkeit von der Zahl Ströme für die Spulen eines Kreuzspulanzeigeinstruments 11, d.h. einen Eingangsstrom, erzeugt.

Der Zähler 5 ist mit einer Vergleichsschaltung 15 verbunden, die überprüft, ob die Periodendauer eine vorbestimmte Länge überschreitet oder nicht. Der Ausgang der Vergleichsschaltung 15 ist mit einem Steuereingang des ersten Umschalters 7 verbunden. Stellt die Vergleichsschaltung 15 fest, daß eine vorbestimmte Periodendauer überschritten worden ist, so schaltet sie den ersten Umschalter 7 um, der daraufhin einen "Null"-Generator 16 mit dem Signaleingang 13 der digitalen Regelung 8 verbindet. Am Signaleingang 13 steht nun nicht mehr die am Ausgang des Dividierers 6 erzeugte digitale Zahl, sondern die Zahl Null an. Die digitale Regelung gibt diese Zahl Null mit einer von der Regelungscharakteristik abhängigen Verzögerungszeit an die Ansteuerlogik 10 weiter, die daraufhin Eingangsströme für das Kreuzspulanzeigeinstrument erzeugt, die den Zeiger des Kreuzspulanzeigeinstruments auf eine vorbestimmte Position bewegen, beispielsweise auf den Anzeigewert Null.

Wie oben erwähnt, ist der Ausgang des Impulsformers 2 mit einem Eingang des zweiten Umschalters 9 verbunden. Der Ausgang des Impulsformers 2 ist weiterhin mit einer 32-Hz-Erkennungsschaltung 20 verbunden, deren Ausgangssignal sich in Abhängigkeit davon ändert, ob die Frequenz des f_{M} des Signals des Signalgebers 1 den Wert 32 Hz überschreitet oder nicht. Wenn die Frequenz f_{M} größer als 32 Hz ist, schaltet das Ausgangssignal der 32-Hz-Erkennungsschaltung 20 den zweiten Umschalter 9 in die mit durchgezogenen Linien dargestellte Stellung, d.h. die Frequenz f_{M} wird dem Takteingang 12 der digitalen Regelung 8 zugeführt. Wenn die Frequenz f_{M} allerdings unter 32 Hz fällt, wird der Umschalter 9 umgeschaltet und verbindet den Takteingang 12 der digitalen Regelung 8 mit einem Ausgang eines 32-Hz-Generators 21. Die digitale Regelung 8 wird dann nicht mehr mit der Frequenz f_{M} des Signals des Signalgebers 1 getaktet, sondern mit der 32-Hz-Frequenz des 32-Hz-Generators 21.

In einer Betriebsweise, in der die Frequenz f_{M} des Signals des Signalgebers 1 größer als 32 Hz ist, ermittelt der Zähler 5 die Periodendauer, die mit Hilfe des Dividierers 6 wieder in eine der Frequenz f_{M} proportionale Zahl umgewandelt wird. Um sprunghafte Änderungen dieser Zahl nicht auf das Anzeigeinstrument 11 durchschlagen zu lassen, verzögert die digitale Regelung die Änderungen, bevorzugterweise durch ein PT₂-Verhalten. Die digitale Regelung wird dabei mit der Frequenz f_{M} des Signals des Signalgebers 1 getaktet, d.h. nach jeder Periode dieses Signals folgt eine Aktualisierung der Zeigerstellung des Änzeigeinstruments 11. Durch die PT₂-Regelung ist die Anderungsgeschwindigkeit der Zeigerstellung begrenzt. Wenn nun die Frequenz f_{M} unter 32 Hz fällt, würde eine Aktualisierung der Zeigerstellung nur in relativ großen Abständen erfolgen, was vom Fahrer eines Kraftfahrzeugs, der das Anzeigeinstrument beobachtet als unangenehmes Zittern oder Schwanken des Zeigers empfunden wird. In dem Augenblick, wo die Frequenz f_{M} unter 32 Hz absinkt, wird die digitale Regelung deswegen nicht mehr mit der Frequenz f_{M} getaktet, sondern konstant mit 32 Hz. Die digitale Regelung 8 begrenzt dabei gleichzeitig die maximale Änderung, die der Zeiger zwischen zwei Stellungen in einer Periode durchführen kann. Dies hat zwar den Nachteil, daß der Zeiger des Anzeigeinstruments 11 dem wahren Meßwert nur mit einer gewissen Verzögerung folgt, der Betrachter empfindet es jedoch als angenehmer, einen Zeiger zu beobachten, der sich kontinuierlich und nicht sprunghaft bewegt.

Eine derartige Betriebsweise tritt z.B. dann auf, wenn die dargestellte Schaltungsanordnung in einem E-Tacho verwendet wird, also einer Geschwindigkeitsanzeigevorrichtung, die mit Hilfe des Kreuzspulanzeigeinstruments 11 die über den Signalgeber 1 ermittelte Geschwindigkeit anzeigt. Unterhalb einer ersten Geschwindigkeit, beispielsweise 25 km/h, wird der Zeigerstand mit 32 Hz aktualisiert. Unterhalb eines zweiten Geschwindigkeitswerts, z.B. 10 km/h, zeigt der Zeiger konstant den Wert Null an.

## Patentansprüche

1. Verfahren zur Erzeugung eines zur Frequenz eines Meßsignals proportionalen Eingangsstroms für ein Kreuzspulanzeigeinstrument, wobei mittels einer konstanten Zählfrequenz zunächst Zahlenwerte entsprechend der Dauer zwischen den steigenden Flanken zweier aufeinanderfolgender Impulse des Meßsignals und daraus mittels Dividierwerk Zahlenwerte entsprechend der Frequenz des Meßsignals gebildet werden, die dann in einem digitalen Regler mit Dämpfungsschaltung in Eingangs-Zahlenwerte für eine Ansteuerlogik umgewandelt werden, aus denen die Ansteuerlogik die Eingangsströme für das Kreuzspulanzeigeinstrument erzeugt, dadurch gekennzeichnet, daß der digitale Regler oberhalb eines ersten vorbestimmten Frequenzwertes mit der Frequenz des Meßsignals und unterhalb des ersten vorbestimmten Frequenzwertes mit einer konstanten Taktfrequenz betrieben wird und daß dem digitalen Regler unterhalb eines zweiten vorbestimmten Frequenzwertes ein vom Meßsignal unabhängiger, Konstanter Zahlenwert zugeführt wird.

2. Verfahren nach Anspruch 1, dadurch gekennzeichnet, daß die konstante Taktfrequenz gleich den ersten vorbestimmten Frequenzwert ist.

3. Verfahren nach Anspruch 1 oder 2, dadurch gekennzeichnet, daß der erste vorbestimmte Frequenzwert größer 25 Hz, insbesondere gleich 32 Hz ist.

4. Verfahren nach Anspruch 3, dadurch gekennzeichnet, daß der zweite vorbestimmte Frequenzwert kleiner ist als der erste vorbestimmte Frequenzwert.

5. Verfahren nach Anspruch 4 oder 3, dadurch gekennzeichnet, daß der dem digitalen Regler zugeführte konstante Zahlenwert dem Skalenanfangswert des Kreuzspulanzeigeinstruments entspricht.

6. Schaltungsanordnung zur Durchführung des Verfahrens nach Anspruch 1 mit einem Signalgeber (1), einem Impulsformer (2), einem Zählerfrequenzgenerator (4), einer Torschaltung (3), einem Zähler (5), einem Dividierer (6), einem digitalen Regler (8) mit Dämpfungsschaltung und einer Ansteuerlogik (10), dadurch gekennzeichnet, daß eine erste Vergleichseinrichtung (20), ein Frequenzgenerator (21) und ein Umschalter (9) vorgesehen sind, mittels derer die Taktfrequenz des digitalen Reglers (8) von der Frequenz des Meßsignals auf eine vom Frequenzgenerator (21) erzeugte konstante Frequenz umschaltbar ist, wenn die Frequenz des Meßsignals einen ersten, in der Vergleichseinrichtung (20) einstellbaren Frequenzwert unterschreitet, und daß außerdem eine zweite Vergleichseinrichtung (15), ein Zahlwertgenerator (16) und ein zweiter Umschalter (7) vorgesehen sind, mittels derer dem digitalen Regler (8) ein vom Meßsignal unabhängiger konstanter Zahlenwert zuführbar ist, wenn die Frequenz des Meßwertes einen zweiten einstellbaren Frequenzwert unterschreitet.

7. Schaltungsanordnung nach Anspruch 6, dadurch gekennzeichnet, daß die im Frequenzgenerator (21) erzeugte Frequenz gleich dem in der Vergleichseinrichtung eingestellten ersten Frequenzwert ist.

8. Schaltungsanordnung nach Anspruch 7 oder 6, dadurch gekennzeichnet, daß der erste eingestellte Frequenzwert größer 25 Hz, insbesondere gleich 32 Hz ist.

## Claims

1. A method of producing an input current, which is proportional to the frequency of a measuring signal, for a crossed-coil indicating instrument, wherein numerical values corresponding to the length of time between the ascending flanks of two successive pulses of the measuring signal are first formed by means of a constant counting frequency and numerical values corresponding to the frequency of the measuring signal are formed therefrom by means of a digital divider, which latter numerical values are then converted in a digital controller with a damping circuit into input numerical values for a triggering logic, from which the triggering logic produces the input currents for the crossed-coil indicating instrument, characterised in that the digital controller is operated above a first predetermined frequency value at the frequency of the measuring signal and below the first predetermined frequency value at a constant clock frequency, and that a constant numerical value which is independent of the measuring signal is fed to the digital controller below a second predetermined frequency value.

2. A method according to claim 1, characterised in that the constant clock frequency is the same as the first predetermined frequency value.

3. A method according to claim 1 or 2, characterised in that the first predetermined frequency value is greater than 25 Hz, and in particular is equal to 32 Hz.

4. A method according to claim 3, characterised in that the second predetermined frequency value is less than the first predetermined frequency value.

5. A method according to claim 4 or 3, characterised in that the constant numerical value fed to the digital controller corresponds to the initial scale value of the crossed-coil indicating instrument.

6. A circuit arrangement for carrying out the method according to claim 1, with a signal transmitter (1), a pulse former (2), a counting frequency generator (4), a gate circuit (3), a counter (5), a divider (6), a digital controller (8) with a damping circuit and a triggering logic (10), characterised in that a first comparison device (20), a frequency generator (21) and a change-over switch (9) are provided, by means of which the clock frequency of the digital controller (8) can be switched over from the frequency of the measuring signal to a constant frequency produced by the frequency generator (21) when the frequency of the measuring signal falls below a first frequency value which can be adjusted in the comparison device (20), and that in addition a second comparison device (15), a numerical value generator (16) and a second change-over switch (7) are provided, by means of which a constant numerical value which is independent of the measuring signal can be fed to the digital controller (8) when the frequency of the measured value falls below a second adjustable frequency value.

7. A circuit arrangement according to claim 6, characterised in that the frequency produced by the frequency generator (21) is equal the frequency value adjusted in the comparison device.

8. A circuit arrangement according to claim 7 or 6, characterised in that the first adjusted frequency value is greater than 25 Hz, and in particular is equal to 32 Hz.

## Revendications

1. Procédé de formation d'un courant d'entrée proportionnel à la fréquence d'un signal de mesure pour un instrument indicateur du type à enroulements croisés, procédé dans lequel on forme au moyen d'une fréquence de comptage constante, d'abord des valeurs numériques correspondant à la durée qui sépare les flancs antérieurs de deux impulsions successives du signal de mesure et on en forme au moyen d'un circuit diviseur des valeurs numériques correspondant à la fréquence de ce signal de mesure, lesquelles sont alors converties dans un circuit régulateur numérique à circuit atténuateur en valeurs numériques d'entrée pour un circuit logique d'asservissement, celui-ci créant à partir de ces dernières valeurs le courant d'entrée pour l'instrument indicateur, ce procédé étant caractérisé en ce que, lorsque la fréquence est supérieure à une première valeur prédéterminée, le circuit régulateur est excité à la fréquence du signal de mesure et, quand la fréquence est inférieure à cette première valeur prédéterminée, il est excité à une fréquence constante et en ce que, lorsque la fréquence est inférieure à une seconde valeur prédéterminée, c'est une fréquence constante, indépendante du signal de mesure, qui est injectée dans le circuit régulateur.

2. Procédé selon la revendication 1, caractérisé en ce que la valeur de la fréquence d'excitation constante est égale à celle de la première fréquence prédéterminée.

3. Procédé selon la revendication 1 ou 2, caractérisé en ce que la première fréquence prédéterminée est supérieure à 25 Hz et est notamment égale à 32 Hz.

4. Procédé selon la revendication 3, caractérisé en ce que la valeur de la seconde fréquence prédéterminée est inférieure à celle de la première fréquence prédéterminée.

5. Procédé selon la revendication 3 ou 4, caractérisé en ce que la valeur numérique constante injectée dans le circuit régulateur correspond à la valeur du début de la graduation de l'instrument indicateur.

6. Montage pour la mise en oeuvre du procédé selon la revendication 1, comportant un générateur (1) de signaux, un formateur (2) d'impulsions, un générateur (4) d'impulsions de comptage, une porte électronique (3), un compteur (5), un diviseur (6), un régulateur numérique (8) à circuit atténuateur et un circuit logique (10) d'asservissement, montage caractérisé en ce qu'il comprend un premier circuit comparateur (20), un générateur (21) de fréquence et un commutateur (9), au moyen desquels il est possible de faire passer le rythme d'excitation du circuit régulateur (8), de la fréquence du signal de mesure à la fréquence constante produite par le générateur (21), lorsque cette fréquence du signal de mesure devient inférieure à une première valeur établie dans le circuit comparateur (20), et en ce qu'il comprend en outre un second circuit comparateur (15), un générateur (16) de valeur de comptage et un second commutateur (7), au moyen desquels une valeur numérique constante et indépendante du signal de mesure peut être injectée dans le circuit régulateur (8), lorsque la fréquence de la valeur de mesure est inférieure à une seconde valeur ajustable.

7. Montage selon la revendication 6, caractérisé en ce que la fréquence émise par le générateur (21) de fréquence est égale à celle qui est établie dans le circuit comparateur (20).

8. Montage selon la revendication 6 ou 7, caractérisé en ce que la première fréquence ajustable est supérieure à 25 Hz et est notamment égale à 32 Hz.
